# EUROPÄISCHE PATENTSCHRIFT

(11) **EP 3 357 133 B1**
(45) Veröffentlichungstag und Bekanntmachung des Hinweises auf die Patenterteilung: **15.02.2023**
(21) Anmeldenummer: 16785104.7
(22) Anmeldetag: 27.09.2016
(51) Int. Cl.: H01S 5/042, H01S 5/16, H01S 5/32, H01S 5/028, H01S 5/323

(54) **HALBLEITERLASER**
SEMICONDUCTOR LASER
LASER À SEMI-CONDUCTEUR

(30) Priorität: 28.09.2015 DE 102015116335
(43) Veröffentlichungstag der Anmeldung: 08.08.2018
(73) Patentinhaber: OSRAM Opto Semiconductors GmbH, 93055 Regensburg (DE)
(72) Erfinder: GERHARD, Sven, 93087 Alteglofsheim (DE); LELL, Alfred, 93142 Maxhütte - Haidhof (DE); VIERHEILIG, Clemens, 93105 Tegernheim (DE); LÖFFLER, Andreas, 93073 Neutraubling (DE); EICHLER, Christoph, 93093 Donaustauf (DE)
(74) Vertreter: Epping - Hermann - Fischer
(86) Internationale Anmeldenummer: PCT/EP2016/073000
(87) Internationale Veröffentlichungsnummer: WO 2017/055284

(56) Entgegenhaltungen:
- EP-A1- 1 460 741
- WO-A1-2014/202619
- US-A1- 2006 176 921
- US-A1- 2010 278 207
- US-A1- 2014 301 419

## Beschreibung

Es wird ein Halbleiterlaser angegeben.

Die Druckschrift US 2010/0278207 A1 betrifft einen Halbleiterlaser mit einer TCO-Mantelschicht und mit einer elektrisch isolierenden Schicht an einer Facette, sodass direkt an der Facette keine Bestromung einer aktiven Zone erfolgt.

Aus der Druckschrift US 2006/0176921 A1 ist ein Halbleiterlaser mit einem Stromschutzbereich an einer Facette bekannt.

In der Druckschrift WO 2014/202619 A1 ist ein Halbleiterlaser mit einer an der Facette verjüngten Halbleiterschicht beschrieben.

Eine zu lösende Aufgabe besteht darin, einen Halbleiterlaser anzugeben, der eine hohe Effizienz und eine große Ausgangsleistung aufweist.

Diese Aufgabe wird durch einen Halbleiterlaser mit den Merkmalen des unabhängigen Patentanspruchs gelöst. Bevorzugte Weiterbildungen sind Gegenstand der abhängigen Ansprüche.

Erfindungsgemäß umfasst der Halbleiterlaser eine Halbleiterschichtenfolge. Die Halbleiterschichtenfolge beinhaltet einen n-leitenden n-Bereich. Ebenso weist die Halbleiterschichtenfolge einen p-leitenden p-Bereich auf. Zwischen dem n-Bereich und dem p-Bereich befindet sich eine aktive Zone. Die aktive Zone ist zur Erzeugung von Laserstrahlung aufgrund von Elektrolumineszenz eingerichtet. Mit anderen Worten folgen entlang oder entgegen einer Wachstumsrichtung der Halbleiterschichtenfolge der n-Bereich, die aktive Zone und der p-Bereich aufeinander, bevorzugt unmittelbar aufeinander.

Die Halbleiterschichtenfolge basiert bevorzugt auf einem III-V-Verbindungshalbleitermaterial. Bei dem Halbleitermaterial handelt es sich zum Beispiel um ein Nitrid-Verbindungshalbleitermaterial wie AlₙIn₁₋ₙ₋ₘGaₘN oder um ein Phosphid-Verbindungshalbleitermaterial wie AlₙIn₁₋ₙ₋ₘGaₘP oder auch um ein Arsenid-Verbindungshalbleitermaterial wie AlₙIn₁₋ₙ₋ₘGaₘAs, wobei jeweils 0 ≤ n ≤ 1, 0 ≤ m ≤ 1 und n + m ≤ 1 ist. Dabei kann die Halbleiterschichtenfolge Dotierstoffe sowie zusätzliche Bestandteile aufweisen. Der Einfachheit halber sind jedoch nur die wesentlichen Bestandteile des Kristallgitters der Halbleiterschichtenfolge, also Al, As, Ga, In, N oder P, angegeben, auch wenn diese teilweise durch geringe Mengen weiterer Stoffe ersetzt und/oder ergänzt sein können.

Gemäß zumindest einer Ausführungsform weist die Laserstrahlung eine Wellenlänge maximaler Intensität auf, die im nahen ultravioletten Spektralbereich liegt. Nahultravioletter Spektralbereich bezeichnet insbesondere Wellenlängen zwischen einschließlich 200 nm und 420 nm oder zwischen einschließlich 320 nm und 420 nm. Alternativ ist der Halbleiterlaser dazu eingerichtet, sichtbare Laserstrahlung zu emittieren, beispielsweise blaue Laserstrahlung oder rote Laserstrahlung. Blaues Licht bezieht sich bevorzugt auf eine Dominanzwellenlänge von mindestens 420 nm und/oder von höchstens 490 nm. Als rotes Licht werden insbesondere Dominanzwellenlängen zwischen einschließlich 600 nm und 700 nm aufgefasst. Weiterhin ist es möglich, dass es sich bei der Laserstrahlung um nahinfrarote Strahlung handelt, also um Strahlung mit einer Wellenlänge maximaler Intensität etwa zwischen einschließlich 700 nm und 1600 nm. Ebenso kann Laserstrahlung im grünen oder gelben Spektralbereich zwischen 490 nm und 600 nm erzeugt werden.

Erfindungsgemäß weist der Halbleiterlaser eine p-Kontaktschicht auf. Die p-Kontaktschicht befindet sich direkt an dem p-Bereich. Ferner ist die p-Kontaktschicht zur Stromeinprägung direkt in den p-Bereich vorgesehen.

Erfindungsgemäß ist die p-Kontaktschicht aus einem für die Laserstrahlung durchlässigen Material hergestellt. So ist die p-Kontaktschicht aus einem Material aus der Klasse der transparenten leitfähigen Oxide, kurz TCOs, hergestellt. TCOs, englisch transparent conductive oxides, sind transparente, elektrisch leitende Materialien, in der Regel Metalloxide, wie beispielsweise Zinkoxid, Zinnoxid, Cadmiumoxid, Titanoxid, Indiumoxid oder Indiumzinnoxid, kurz ITO. Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein.

Erfindungsgemäß umfasst der Halbleiterlaser eine p-Kontaktstruktur. Die p-Kontaktstruktur befindet sich direkt an der p-Kontaktschicht. Über die p-Kontaktstruktur wird die p-Kontaktschicht bestromt. Die p-Kontaktstruktur ist somit elektrisch leitend.

Erfindungsgemäß ist die p-Kontaktstruktur aus einem Metall oder aus einer Metalllegierung gebildet. Dabei kann die p-Kontaktstruktur aus mehreren Teilschichten zusammengesetzt sein. Bevorzugt umfasst die p-Kontaktstruktur eines oder mehrerer der nachfolgend genannten Metalle oder besteht aus einem oder aus mehreren dieser Metalle, durchmischt oder in Teilschichten: Au, Ag, Ni, Sn, Pd, Pt, Rh, Ti.

Erfindungsgemäß ist die p-Kontaktschicht ein Teil einer Mantelschicht des Halbleiterlasers. Mit anderen Worten ist die p-Kontaktschicht zur Führung einer Laserstrahlung innerhalb des Halbleiterlasers eingerichtet. Mantelschicht bedeutet, dass diese Schicht einen niedrigeren optischen Brechungsindex für die Laserstrahlung aufweist als eine Wellenleiterschicht, an die die Mantelschicht grenzt. Mit anderen Worten dient die Mantelschicht dazu, in der aktiven Zone die Laserstrahlung über Totalreflexion zu führen. Ein Brechungsindex der p-Kontaktschicht ist somit niedriger als ein effektiver Brechungsindex für die Laserstrahlung in der aktiven Zone.

Erfindungsgemäß weist die Halbleiterschichtenfolge zwei oder mehr als zwei Facetten auf. Die Facetten bilden Endflächen für einen Resonator, in dem die Laserstrahlung erzeugt und geführt wird. Insbesondere ist dabei eine der Facetten hochreflektierend beschichtet, so dass eine Reflektivität dieser Facette für die Laserstrahlung bevorzugt bei mindestens 90 % oder 95 % oder 99 % oder 99,8 % liegt. Eine weitere Facette ist bevorzugt zur Auskopplung der Laserstrahlung aus dem Halbleiterlaser eingerichtet, diese Facette weist beispielsweise eine vergleichsweise geringe Reflektivität für die Laserstrahlung von höchstens 50 % oder 70 % oder 85 % auf. Mit anderen Worten bilden die beiden Facetten, die sich bevorzugt aneinander gegenüberliegenden Enden der Halbleiterschichtenfolge befinden, für die Laserstrahlung zwei Resonatorendflächen aus, zwischen denen ein Resonator verläuft.

Erfindungsgemäß weist der Halbleiterlaser einen Stromschutzbereich auf. Der Stromschutzbereich befindet sich direkt an zumindest einer der Facetten. Bevorzugt ist an jeder der Facetten, an der die Laserstrahlung hingelangt, ein Stromschutzbereich vorhanden. In dem mindestens einen Stromschutzbereich ist eine Einprägung von Strom in den p-Bereich unterdrückt. Beispielsweise ist eine Stromeinprägung in dem Stromschutzbereich im Vergleich zu übrigen Bereichen des p-Bereichs um mindestens einen Faktor 10 oder 100 oder 500 verringert. Da der p-Bereich in Richtung parallel zur aktiven Zone eine nur geringe elektrische Leitfähigkeit aufweist, ist somit eine Bestromung der aktiven Zone direkt an den Facetten verhinderbar.

Erfindungsgemäß weist der Stromschutzbereich in Richtung senkrecht zur zugehörigen Facette eine Ausdehnung von größer 0 auf. So liegt die Ausdehnung bei mindestens 0,5 µm oder 5 µm oder 10 µm und bei höchstens 100 µm oder 30 µm oder 20 µm. Weiterhin beträgt die Ausdehnung des Stromschutzbereichs höchstens 20 % oder 10 % oder 5 % oder 2 % einer Länge des Resonators für die Laserstrahlung beträgt.

Erfindungsgemäß umfasst der Halbleiterlaser eine Halbleiterschichtenfolge. Die Halbleiterschichtenfolge umfasst einen n-leitenden n-Bereich, einen p-leitenden p-Bereich und eine dazwischenliegende aktive Zone zur Erzeugung von Laserstrahlung. Zur Stromeinprägung befindet sich direkt an dem p-Bereich eine für die Laserstrahlung durchlässige p-Kontaktschicht. Direkt an der p-Kontaktschicht ist eine elektrisch leitende und metallische p-Kontaktstruktur angebracht. Die p-Kontaktschicht ist dabei ein Teil einer Mantelschicht zur Führung der Laserstrahlung. Zwei Facetten der Halbleiterschichtenfolge bilden Resonatorendflächen für die Laserstrahlung. In wenigstens einem Stromschutzbereich direkt an zumindest einer der Facetten ist eine Stromeinprägung in den p-Bereich unterdrückt. Der Stromschutzbereich weist in Richtung senkrecht zur zugehörigen Facette eine Ausdehnung von mindestens 0,5 µm und von höchstens 100 µm und zusätzlich von höchstens 20 % einer Resonatorlänge für die Laserstrahlung auf.

In den vergleichsweise stark wachsenden Märkten von laserbasierten Anwendungen, zum Beispiel für Projektion, Beleuchtung oder Materialbearbeitung, kommen herkömmliche Laserdioden hinsichtlich ihrer maximalen Ausgangsleistung, Effizienz und Lebensdauer an Grenzen. Bei dem hier beschriebenen Halbleiterlaser ist durch die transparente p-Kontaktschicht eine effiziente Wellenführung mit geringen optischen Verlusten bei gleichzeitig geringer Betriebsspannung erzielbar. Ebenso ist aufgrund des Stromschutzbereichs eine spontane Ausfallrate aufgrund von optischen Schäden an den Facetten, auch bezeichnet als Catastrophic Optical Damage oder kurz COD, reduziert. Weiterhin kann der p-Bereich der Halbleiterschichtenfolge dünner ausgeführt werden, da die p-Kontaktschicht ein Teil der zugehörigen Mantelschicht ist. Hierdurch ist eine Betriebsspannung reduzierbar.

Gemäß zumindest einer Ausführungsform schließen die p-Kontaktschicht und/oder die p-Kontaktstruktur in Richtung parallel zur aktiven Zone bündig mit einer Facette und/oder Resonatorendfläche ab.

Erfindungsgemäß dringt die Laserstrahlung im Betrieb des Halbleiterlasers bestimmungsgemäß in die p-Kontaktschicht ein. Mit anderen Worten ist die p-Kontaktschicht ein Teil eines Systems zur Wellenführung in dem Halbleiterlaser.

Gemäß zumindest einer Ausführungsform befindet sich in einem weiteren Stromschutzbereich zwischen der p-Kontaktschicht und dem p-Bereich eine elektrische Isolatorschicht. Die Isolatorschicht ist elektrisch isolierend oder auch elektrisch schlecht leitend, sodass die Leitfähigkeit der Isolatorschicht dann um mindestens einen Faktor 10 oder 100 oder 1000 geringer ist als eine Leitfähigkeit der p-Kontaktschicht. Die Isolatorschicht ist beispielsweise aus einem keramischen Material, einem Glas, einem Dielektrikum, einem Nitrid und/oder einem Oxid gebildet. Beispielsweise besteht oder umfasst die Isolatorschicht eines oder mehrerer der nachfolgend genannten Materialien: Al₂O₃, SiO₂, TiO₂, Ta₂O₅, HfO₂, Si₃N₄, AlN, SiC, diamantähnlicher Kohlenstoff, englisch Diamond-Like-Carbon oder kurz DLC. Die Isolatorschicht ist bevorzugt mittels Atomlagenabscheidung, kurz ALD, hergestellt. Alternativ ist es möglich, dass die Isolatorschicht über Sputtern, chemische Gasphasenabscheidung oder Bedampfen hergestellt wird.

Gemäß zumindest einer Ausführungsform weist die Isolatorschicht in dem gesamten Stromschutzbereich eine konstante Dicke auf. Mit anderen Worten ist dann keine gezielte Dickenvariation der Isolatorschicht eingestellt.

Gemäß zumindest einer Ausführungsform liegt eine Dicke der Isolatorschicht bei höchstens 75 % oder 50 % oder 20 % oder 5 % einer Dicke der p-Kontaktschicht. Alternativ oder zusätzlich beträgt die Dicke der Isolatorschicht mindestens 20 nm oder 50 nm oder 100 nm und/oder höchstens 1 µm oder 500 nm oder 100 nm. Alternativ kann die Isolatorschicht genauso dick sein wie die p-Kontaktschicht.

Gemäß zumindest einer Ausführungsform ist in einem weiteren Stromschutzbereich der p-Bereich direkt an der p-Kontaktschicht modifiziert. Durch die Modifizierung ist in diesem Stromschutzbereich eine Stromeinprägung in den p-Bereich verhindert oder stark reduziert. Beispielsweise ist in dem Stromschutzbereich an dem p-Bereich eine Aufrauhung erzeugt oder eine Kristallqualität der Halbleiterschichtenfolge und/oder eine p-Leitfähigkeit der Halbleiterschichtenfolge reduziert. Dies ist beispielsweise durch Rücksputtern, Ätzen oder durch Plasmaschädigung der Halbleiterschichtenfolge erreichbar. Mit anderen Worten wird durch die Modifikation ein Kontaktwiderstand zwischen der p-Kontaktschicht und dem p-Bereich erhöht.

Gemäß zumindest einer Ausführungsform ist in einem weiteren Stromschutzbereich die p-Kontaktschicht direkt an dem p-Bereich modifiziert. Durch die Modifizierung der p-Kontaktschicht ist in diesem Stromschutzbereich eine Stromeinprägung in den p-Bereich verringert. Beispielsweise bei einer transparenten leitfähigen Oxid für die p-Kontaktschicht ist durch eine angepasste Temperaturbehandlung in Kombination mit einer selektiven Abdeckung ein Kontaktwiderstand und/oder eine Stromleitfähigkeit hin zu dem p-Bereich einstellbar.

In einer Ausführungsform sind in dem mindestens einen Stromschutzbereich die p-Kontaktschicht und die p-Kontaktstruktur vollständig entfernt. In diesem Stromschutzbereich sind die p-Kontaktschicht und die p-Kontaktstruktur bevorzugt auch nicht durch andere Komponenten des Halbleiterlasers ersetzt. Beispielsweise ist an dem Stromschutzbereich eine Ausnehmung oder ein Hohlraum an der Stelle der p-Kontaktschicht und/oder der p-Kontaktstruktur gebildet.

In einer Ausführungsform ist die p-Kontaktschicht in dem Stromschutzbereich entfernt und in dem Stromschutzbereich befindet sich zumindest eine Zusatzschicht. Die eine oder die mehreren Zusatzschichten sind elektrisch isolierend und bevorzugt direkt an dem p-Bereich aufgebracht. Weiterhin bevorzugt weist die zumindest eine Zusatzschicht eine höhere spezifische thermische Leitfähigkeit auf als der p-Bereich und/oder als die p-Kontaktschicht. Die Zusatzschicht kann aus denselben Materialien gebildet sein wie die Isolatorschicht. Insofern wird hinsichtlich der Materialien für die Zusatzschicht auf die Ausführungen zur Isolatorschicht verwiesen.

In einer nicht erfindungsgemäßen Abwandlung weist in dem zumindest einen Stromschutzbereich der p-Bereich eine größere Dicke auf als in verbleibenden Gebieten der Halbleiterschichtenfolge. Die p-Kontaktschicht ist in dem Stromschutzbereich nicht vorhanden. Beispielsweise ist der p-Bereich außerhalb des Stromschutzbereichs durch Ätzen entfernt und nachfolgend mit der p-Kontaktschicht aufgefüllt.

Dabei ist es möglich, dass die p-Kontaktschicht in Richtung weg von der aktiven Zone bündig mit dem p-Bereich abschließt, zumindest an einer Grenze zwischen dem Stromschutzbereich und zwischen verbleibenden Gebieten der Halbleiterschichtenfolge.

Gemäß der Erfindung wie in Anspruch 1 definiert, ist in einem Stromschutzbereich die p-Kontaktschicht nur teilweise entfernt. So liegt dann ein durch die p-Kontaktschicht graduell sich ändernder Brechungsindex in dem Stromschutzbereich vor. Ein effektiver Brechungsindex für die Laserstrahlung in der p-Kontaktschicht in dem Stromschutzbereich nimmt dabei in Richtung hin zur zugehörigen Facette und/oder in Richtung weg von der aktiven Zone ab. Hierdurch sind optische Verluste an der Facette an dem Stromschutzbereich reduzierbar.

Gemäß zumindest einer Ausführungsform ist die p-Kontaktschicht unmittelbar an der zugehörigen Facette vollständig entfernt. Dieser Bereich, in dem die p-Kontaktschicht vollständig entfernt ist, weist bevorzugt eine Ausdehnung in Richtung senkrecht zu dieser Facette von mindestens 0,5 µm oder 2 µm oder 5 µm auf und alternativ oder zusätzlich von höchstens 70 % oder 50 % oder 20 % der Ausdehnung des zugehörigen Stromschutzbereichs, also in diesem Fall des Bereichs, in dem die p-Kontaktschicht zumindest teilweise entfernt ist.

Gemäß zumindest einer Ausführungsform ist in einem weiteren Stromschutzbereich die p-Kontaktschicht teilweise entfernt und Gebiete, aus denen die p-Kontaktschicht entfernt ist, sind mit einem für die Laserstrahlung transparenten und elektrisch isolierenden oder elektrisch schlecht leitenden Schutzmaterial aufgefüllt. Schlecht leitend kann bedeuten, dass dann die Leitfähigkeit des Schutzmaterials um mindestens einen Faktor 10 oder 100 oder 1000 geringer ist als eine Leitfähigkeit der p-Kontaktschicht. Das Schutzmaterial kann aus den gleichen Materialien gebildet sein wie die Isolatorschicht. Die p-Kontaktschicht insgesamt zusammen mit dem Schutzmaterial bildet bevorzugt eine Schicht mit einander gegenüberliegenden, planparallelen Begrenzungsflächen und mit einer konstanten, gleichbleibenden Dicke.

Gemäß zumindest einer Ausführungsform sind in einem weiteren Stromschutzbereich ein Material der p-Kontaktschicht und ein Mischmaterial durchmischt. Das Mischmaterial ist dabei elektrisch isolierend und bevorzugt transparent für die Laserstrahlung. Ein Anteil des Mischmaterials nimmt hin zur betreffenden Facette und/oder in Richtung weg von der aktiven Zone dabei graduell oder stufenförmig zu.

Gemäß zumindest einer Ausführungsform ist eine Seitenfläche der p-Kontaktschicht vollständig von dem Schutzmaterial, von einem Material der Isolatorschicht und/oder von einem Material der p-Kontaktstruktur bedeckt. Die Seitenfläche ist dabei bevorzugt parallel oder näherungsweise parallel zur zugehörigen Facette ausgerichtet.

Gemäß zumindest einer Ausführungsform folgen in Richtung hin zur Facette und parallel zur aktiven Zone die p-Kontaktschicht, die p-Kontaktstruktur und die Zusatzschicht aufeinander, insbesondere unmittelbar aufeinander. Der Stromschutzbereich ist dabei entweder einzig durch den Bereich mit der Zusatzschicht oder durch den Bereich mit der Zusatzschicht und mit der p-Kontaktstruktur gebildet, abhängig von einem Kontaktwiderstand zwischen dem p-Bereich und der p-Kontaktstruktur.

Gemäß zumindest einer Ausführungsform ist die Zusatzschicht sowohl in dem Stromschutzbereich als auch auf der zugehörigen Facette aufgebracht. Bei der Zusatzschicht kann es sich um einen Schichtenstapel handeln, über den eine Reflektivität der zugehörigen Facette eingestellt ist. Beispielsweise ist die Zusatzschicht als Antireflexionsschicht oder als hochreflektierender Spiegel gestaltet. Die Zusatzschicht kann eine Abfolge von Schichten mit abwechselnd hohem und niedrigem Brechungsindex für die Laserstrahlung aufweisen.

Gemäß zumindest einer Ausführungsform ist nahe von zumindest einem Stromschutzbereich die Zusatzschicht auf die p-Kontaktschicht aufgebracht. In diesem Fall kann die Zusatzschicht in direktem Kontakt zu der p-Kontaktstruktur stehen. Der Stromschutzbereich ist insbesondere nur der Bereich, in dem die Zusatzschicht in direktem Kontakt zu dem p-Bereich steht.

Gemäß zumindest einer Ausführungsform ist in dem Stromschutzbereich die Zusatzschicht teilweise oder vollständig von der p-Kontaktstruktur bedeckt. Insbesondere kann dann p-Kontaktstruktur bündig mit der zugehörigen Facette abschließen.

Gemäß zumindest einer Ausführungsform ist eine Dicke der Zusatzschicht gleich einer Dicke der p-Kontaktschicht. Alternativ ist es möglich, dass die Zusatzschicht eine Dicke aufweist, die gleich einer Gesamtdicke aus der p-Kontaktschicht und der p-Kontaktstruktur ist. Weiterhin ist es möglich, dass die Dicke der Zusatzschicht größer ist als die Dicke der p-Kontaktschicht, aber kleiner als die Dicke der p-Kontaktstruktur.

Gemäß zumindest einer Ausführungsform ist die Zusatzschicht von der p-Kontaktschicht und/oder von der p-Kontaktstruktur beabstandet, in Richtung parallel zur aktiven Zone. In Richtung parallel zur aktiven Zone kann dann ein Hohlraum zwischen der Zusatzschicht und der p-Kontaktschicht und/oder der p-Kontaktstruktur ausgebildet sein.

Nachfolgend wird ein hier beschriebener Halbleiterlaser unter Bezugnahme auf die Zeichnung näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:
- Figuren 7 bis 8: schematische Schnittdarstellungen von Ausführungsbeispielen von hier beschriebenen Halbleiterlasern,
- Figuren 1 bis 6 und 9 bis 18: schematische Schnittdarstellungen von nicht erfindungsgemäßen Abwandlungen von Halbleiterlasern, und
- Figur 19: eine schematische Schnittdarstellung einer nicht erfindungsgemäßen Abwandlung eines Halbleiterlasers.

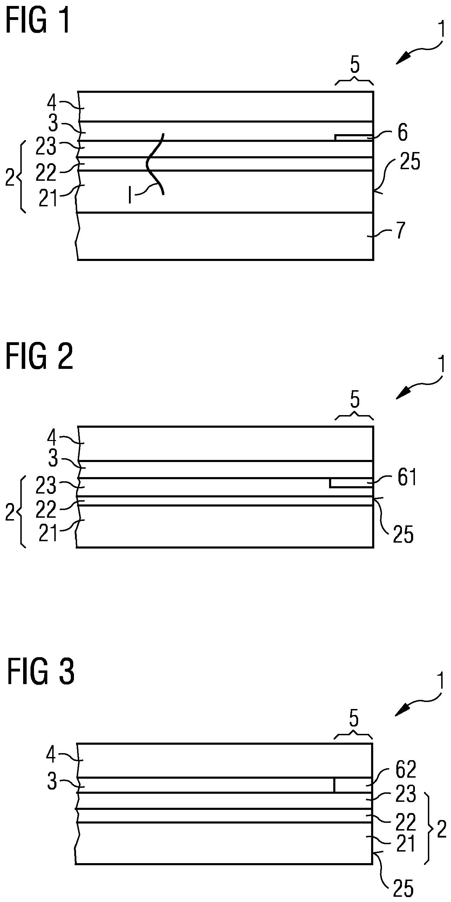

In Figur 1 ist eine Abwandlung eines Halbleiterlasers 1 gezeigt. Auf einem Substrat 7 befindet sich eine Halbleiterschichtenfolge 2. Die Halbleiterschichtenfolge 2 weist einen n-leitenden n-Bereich 21, eine aktive Zone 22 und einen p-leitenden p-Bereich 23 auf. Der n-Bereich 21, die aktive Zone 22 und der p-Bereich 23 folgen in Richtung weg von dem Substrat 7 unmittelbar aufeinander.

Eine Stromeinprägung in die Halbleiterschichtenfolge 2 erfolgt einerseits aus Richtung von dem Substrat 7 und/oder von dem n-Bereich 21 her sowie von einer p-Kontaktschicht 3 und einer p-Kontaktstruktur 4 her. Die p-Kontaktstruktur 4 ist aus zumindest einem Metall gebildet. Insbesondere ist über die p-Kontaktstruktur 4 der Halbleiterlaser 1 extern elektrisch kontaktierbar, beispielsweise über Löten oder über einen Bonddraht. Bei der p-Kontaktschicht 3 handelt es sich um eine transparente leitende Schicht, insbesondere aus ITO, In₂O₃, SnO₂ oder ZnO oder Kombinationen hieraus.

Die p-Kontaktschicht 3 ist Teil einer Mantelschicht des Halbleiterlasers 1. Demgemäß liegt eine endliche Intensität I einer in der aktiven Zone 22 erzeugten Laserstrahlung bestimmungsgemäß noch in der p-Kontaktschicht 3 vor. Beispielsweise ist ein Wellenleiter im Wesentlichen auf die aktive Zone 22 begrenzt und Mantelschichten zur Wellenführung sind einerseits durch den n-Bereich 21 und andererseits durch den p-Bereich 23 zusammen mit der p-Kontaktschicht 3 gebildet.

In Richtung parallel zur aktiven Zone 22 wird die Halbleiterschichtenfolge 2 durch eine Facette 25 begrenzt. An der Facette 25 erfolgt eine Reflexion oder eine Auskopplung der erzeugten Laserstrahlung. Dementsprechend ist an der Facette 25 bevorzugt eine hochreflektierende oder eine antireflektierende Schicht aufgebracht, nicht gezeichnet. In allen Ausführungsbeispielen befindet sich ferner bevorzugt je eine nicht gezeichnete Passivierungsschicht an der Halbleiterschichtenfolge 2.

Nahe an der Facette 25 befindet sich in einem Stromschutzbereich 5 eine Isolatorschicht 6 direkt auf dem p-Bereich 23 und unterhalb der p-Kontaktschicht 3. Durch die Isolatorschicht 6 ist eine Stromeinprägung von der p-Kontaktschicht 3 in den p-Bereich 23 direkt an der Facette 25 unterbunden. In Richtung weg von der Facette 25 weist der Stromschutzbereich 5 bevorzugt eine Ausdehnung von 5 µm bis 40 µm oder von 10 µm bis 20 µm auf.

Wie auch in allen anderen Abwandlungen oder Ausführungsbeispielen weist der p-Bereich 23 zusammen mit der p-Kontaktschicht 3 eine ausreichende Dicke auf, um die Laserstrahlung von der metallischen und damit vergleichsweise stark absorbierenden p-Kontaktstruktur 4 fernzuhalten. Mit anderen Worten ist die Intensität I an der Kontaktstruktur 4 vernachlässigbar, im Gegensatz zu einer Intensität in der p-Kontaktschicht 3 selbst. Eine Dicke der bevorzugt gleichbleibend dicken p-Kontaktschicht 3 liegt zum Beispiel bei mindestens 5 nm oder 50 nm oder 100 nm und/oder bei höchstens 1 µm oder 0,5 µm oder 250 nm, etwa zwischen einschließlich 100 nm und 250 nm. Durch die Verwendung der p-Kontaktschicht 3 als Teil einer Mantelschicht ist es möglich, den verbleibenden p-Bereich 23 relativ dünn zu gestalten. Hierdurch ist eine Reduktion einer Vorwärtsspannung des Halbleiterlasers 1 möglich.

In den übrigen Abwandlungen und Ausführungsbeispielen ist ein Verlauf der Intensität I und das Substrat 7 jeweils nicht gezeichnet. Jedoch gilt diesbezüglich bevorzugt in den übrigen Abwandlungen und Ausführungsbeispielen das gleiche, wie in Verbindung mit Figur 1 erläutert, soweit nicht anders dargestellt.

Bei der Abwandlung der Figur 2 ist der Stromschutzbereich 5 durch eine lokale Modifikation 61 des p-Bereichs 23 gebildet. Beispielsweise ist über Rücksputtern, Ätzen oder Plasmaschädigung des p-Bereichs 23 lokal ein Kontaktwiderstand zwischen der Halbleiterschichtenfolge 2 und der p-Kontaktschicht 3 erhöht, so dass im Stromschutzbereich 5 kein oder im Wesentlichen kein Strom in die Halbleiterschichtenfolge 2 eingeprägt wird.

Bei der Abwandlung der Figur 3 ist in dem Stromschutzbereich 5 eine Modifikation 62 in der p-Kontaktschicht 3 selbst gebildet. Beispielsweise ist in der Modifikation 62 die p-Kontaktschicht 3 einer Temperaturbehandlung, insbesondere einem Tempern, unterworfen, so dass ein Kontaktwiderstand hin zum p-Bereich erhöht ist oder so dass eine elektrische Leitfähigkeit in der Modifikation 62 gegenüber verbleibenden Bereichen der p-Kontaktschicht 3 herabgesetzt ist.

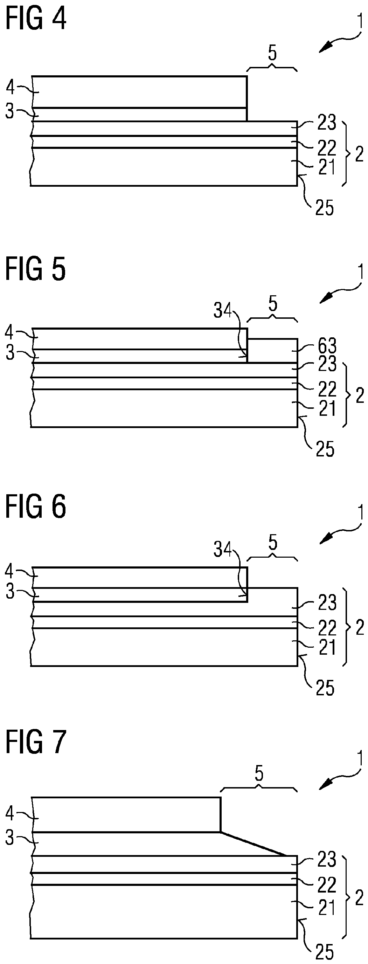

Bei den Abwandlungen der Figuren 1 bis 3 schließen sowohl die p-Kontaktschicht 3 als auch die p-Kontaktstruktur 4 jeweils bündig mit der Facette 25 an der Halbleiterschichtenfolge 2 ab. Bei der Abwandlung der Figur 4 hingegen sind sowohl die p-Kontaktstruktur 4 als auch die p-Kontaktschicht 3 vollständig aus dem Stromschutzbereich 5 entfernt.

Bei der Abwandlung der Figur 5 ist in dem Stromschutzbereich 5 eine Zusatzschicht 63 aufgebracht. Die Zusatzschicht 63 ist bevorzugt aus einem für die Laserstrahlung transparenten Material mit einem vergleichsweise niedrigen Brechungsindex hergestellt. Ebenso ist es möglich, dass die Zusatzschicht 63 einen Brechungsindex aufweist, der von einem Brechungsindex der Kontaktstruktur 3 nur um höchstens 0,2 oder 0,1 oder 0,05 abweicht. Durch die Zusatzschicht ist eine Wellenführung der Laserstrahlung im Bereich der Facette 25 möglich.

Die Zusatzschicht 63 kann eine Dicke aufweisen, die größer ist als die Dicke der p-Kontaktschicht 3. Alternativ ist es möglich, dass die Dicke der Zusatzschicht 63 gleich oder auch kleiner der Dicke der p-Kontaktschicht 3 ist. Beispielsweise ist die Zusatzschicht 63 aus einem elektrisch schlecht leitenden Material wie Al₂O₃, SiO₂, TiO₂, Ta₂O₅, HfO₂, Si₃N₄ oder AlN gebildet.

Alternativ ist es möglich, dass die Zusatzschicht 63 aus einem elektrisch nicht leitenden, aber thermisch gut leitenden Material gebildet ist, um eine thermische Anbindung des Bereichs nahe der Facette 25 an die thermisch gut leitende p-Kontaktstruktur 4 zu gewährleisten. Materialien für die Zusatzschicht 63 sind dann insbesondere diamantähnlicher Kohlenstoff, SiC oder AlN. Eine spezifische Wärmeleitfähigkeit des Materials für die Zusatzschicht 63 liegt in diesem Fall bevorzugt bei mindestens 10 W/m·K oder 50 W/m·K oder 100 W/m·K.

Bei der Abwandlungder Figur 6 ist der p-Bereich 23 strukturiert. Außerhalb des Stromschutzbereichs 5 ist eine Dicke des p-Bereichs 23 reduziert. Somit ist in dem p-Bereich 23 außerhalb des Stromschutzbereichs 5 eine Ausnehmung gebildet. Eine Tiefe dieser Ausnehmung liegt bevorzugt bei mindestens 10 nm oder 50 nm oder 100 nm und/oder bei höchstens 1 µm oder 0,5 µm oder 250 nm. Diese Ausnehmung ist vollständig oder teilweise von der p-Kontaktschicht 3 aufgefüllt.

Gemäß Figur 6 schließt die p-Kontaktschicht 3 in Richtung weg von der aktiven Zone 22 bündig mit dem p-Bereich 23 in dem Stromschutzbereich 5 ab. Alternativ kann die p-Kontaktschicht 3 in dieser Ausnehmung auch eine geringere oder eine größere Dicke aufweisen und somit von dem p-Bereich 23 überragt werden oder umgekehrt.

Gemäß dem Ausführungsbeispiel in Figur 7 läuft die p-Kontaktschicht 3 in dem Stromschutzbereich 5 kontinuierlich hin zur Facette 25 aus. Hierdurch ist ein gradueller Übergang des Brechungsindexes für die Laserstrahlung hin zur Facette 25 erreichbar, wodurch optische Verluste reduzierbar sind. Ein Bereich direkt an der Facette 25 ist bevorzugt gänzlich frei von der p-Kontaktschicht 3. Anders als dargestellt kann die p-Kontaktschicht 3 hin zur Facette 25 nicht nur linear, sondern auch gekrümmt auslaufen.

Durch eine innere Strukturierung der p-Kontaktschicht 3 ist es auch möglich, dass in Richtung weg von der aktiven Zone 22 der Brechungsindex in den Stromschutzbereich 5 abnimmt. Dies ist beispielsweise durch Ausnehmungen in der p-Kontaktschicht 3 möglich, deren Volumenanteil in Richtung weg von der aktiven Zone 22 zunimmt.

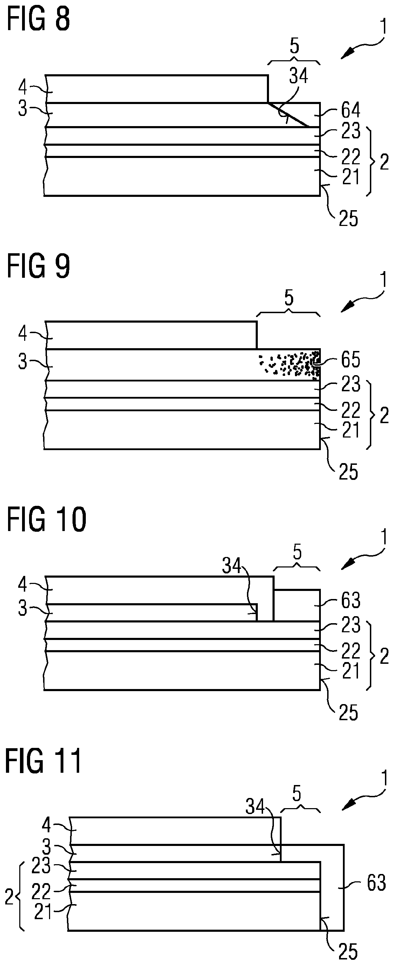

Beim Ausführungsbeispiel der Figur 8 ist der aus der p-Kontaktschicht 3 entfernte Bereich durch ein Schutzmaterial 64 aufgefüllt, so dass insgesamt wiederum eine Schicht mit einer gleichbleibenden konstanten Schichtdicke resultiert, die bis hin zur Facette 25 reicht. Für das Schutzmaterial 64 können die gleichen Materialien verwendet werden wie für die Isolatorschicht 6, die wiederum aus denselben Materialien gebildet sein kann wie die Zusatzschicht 63.

Bei der Abwandlung der Figur 9 sind in den Stromschutzbereich 5 das Material der p-Kontaktschicht 3 mit einem Mischmaterial 65 durchmischt. Hierbei nimmt ein Anteil des Mischmaterials 65 in Richtung hin zur Facette 25 monoton und graduell zu. Zum Beispiel ändern sich Anteile von In, Sn, N, O und/oder Zn in Richtung hin zur Facette 25, insbesondere kann eine Zusammensetzung von ITO variiert sein.

In der Abwandlung der Figur 10 ist die Seitenfläche 34 der p-Kontaktschicht 3 vollständig von der p-Kontaktstruktur 4 bedeckt. Somit ist die p-Kontaktstruktur 4 im Querschnitt gesehen L-förmig gestaltet. Beispielsweise bei einem Erzeugen der Facetten 25 oder bei anderen Verarbeitungsschritten ist es hierdurch möglich, dass die metallische p-Kontaktstruktur 4 die p-Kontaktschicht 3 schützt. Optional ist wiederum die Zusatzschicht 63 vorhanden, die sich direkt an die p-Kontaktstruktur 4 anschließt, in Richtung weg von der p-Kontaktschicht 3.

Bei der Abwandlung der Figur 11 ist die Zusatzschicht 33 sowohl in Verlängerung der p-Kontaktschicht 3 als auch an der Facette 25 angebracht. Dabei ist die Zusatzschicht 63 bevorzugt als Antireflexschicht oder als hochreflektierende Schicht für die in der aktiven Zone 22 erzeugte Laserstrahlung ausgeführt. Dabei kann eine Dicke der Zusatzschicht 63 an der Facette 25 gleich einer Dicke an dem p-Bereich 23, in Verlängerung der p-Kontaktschicht 3, sein. Ebenso können die Dicken an den unterschiedlichen Schenkeln der im Querschnitt gesehenen L-förmigen Zusatzschicht 63 voneinander verschieden sein. Ebenso ist es möglich, dass die Facette 25 nur teilweise von der Zusatzschicht 63 bedeckt ist, anders als in Figur 11 dargestellt. Weiterhin kann die Zusatzschutzschicht 63, abweichend von der Darstellung in Figur 11, die p-Kontaktstruktur 4 teilweise bedecken.

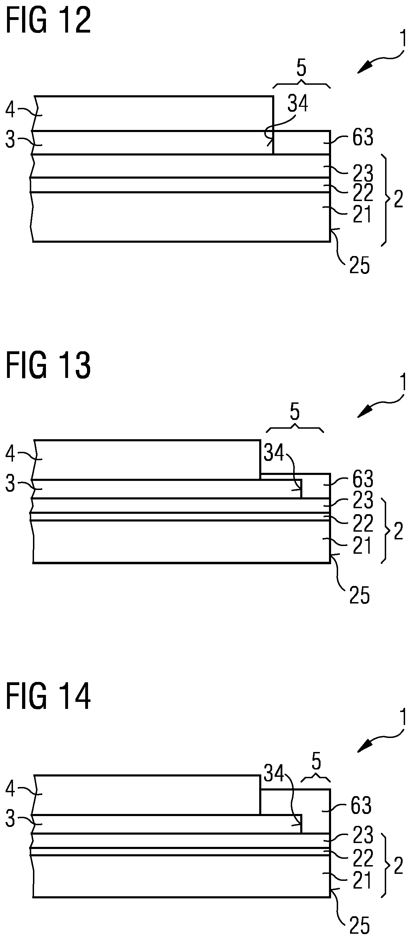

Bei der Abwandlung der Figur 12 schließt die Zusatzschicht 23 in Richtung weg von der aktiven Zone bündig mit der p-Kontaktschicht 3 ab. Die p-Kontaktschicht 3 und die p-Kontaktstruktur 4 enden bündig zueinander, in Richtung senkrecht zur Facette 25. Eine entsprechende Gestaltung der Zusatzschicht 63 kann auch in den Figuren 5, 10 oder 11 vorliegen.

Gemäß der Abwandlung, wie in Figur 13 gezeigt, überragt die p-Kontaktschicht 3 die p-Kontaktstruktur 4, in Richtung hin zur Facette 25. Die Zusatzschicht 63 bedeckt dabei die p-Kontaktschicht 3 vollständig, zusammen mit der p-Kontaktstruktur 4. In dem Bereich, in dem die Zusatzschicht 63 auf der p-Kontaktschicht 3 aufgebracht ist, weist die Zusatzschicht 63 bevorzugt eine geringere Dicke auf als die p-Kontaktschicht 3.

Anders als in Figur 13 ist die Zusatzschicht 63 oberhalb der p-Kontaktschicht 3, in Richtung weg von der aktiven Zone 22, in der Abwandlung der Figur 14 vergleichsweise dick gestaltet, insbesondere dicker als die p-Kontaktschicht 3 selbst.

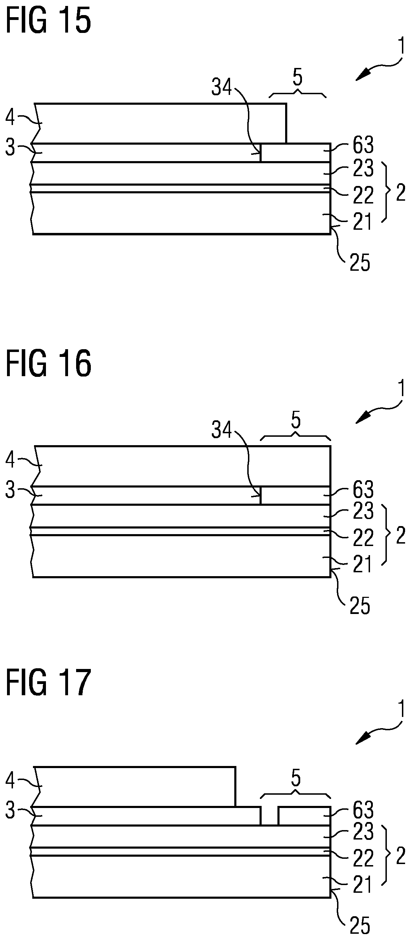

Abweichend von der Darstellung in Figur 14 ist es, ebenso wie in den Figuren 5 und 10 bis 13, jeweils möglich, dass die Zusatzschicht 63 nicht bis ganz an die Facette 25 heranreicht. Gleiches gilt auch hinsichtlich der Figuren 15 bis 17.

Bei der Abwandlung der Figur 15 ist die Zusatzschicht 63, die die Seitenflächen 34 der p-Kontaktschicht 3 vollständig bedeckt, teilweise von der p-Kontaktstruktur 4 überformt. Anders als dargestellt kann eine seitliche Begrenzungsfläche der p-Kontaktstruktur 4 nicht nur parallel zur Facette 25, sondern auch schräg zur Facette 25 oder auch abgerundet verlaufend gestaltet sein.

Abweichend von Figur 15 bedeckt gemäß der Abwandlung in Figur 16 die p-Kontaktstruktur 4 die Zusatzschicht 63 vollständig.

Bei der Abwandlung, wie in Figur 17 gezeigt, befindet sich zwischen der p-Kontaktschicht 3 und der Zusatzschicht 63, in Richtung parallel zur aktiven Zone 22, ein Zwischenraum, insbesondere ein Hohlraum. Die p-Kontaktstruktur 4 und die p-Kontaktschicht 3 verlaufen in Richtung hin zur Facette 25 stufenförmig.

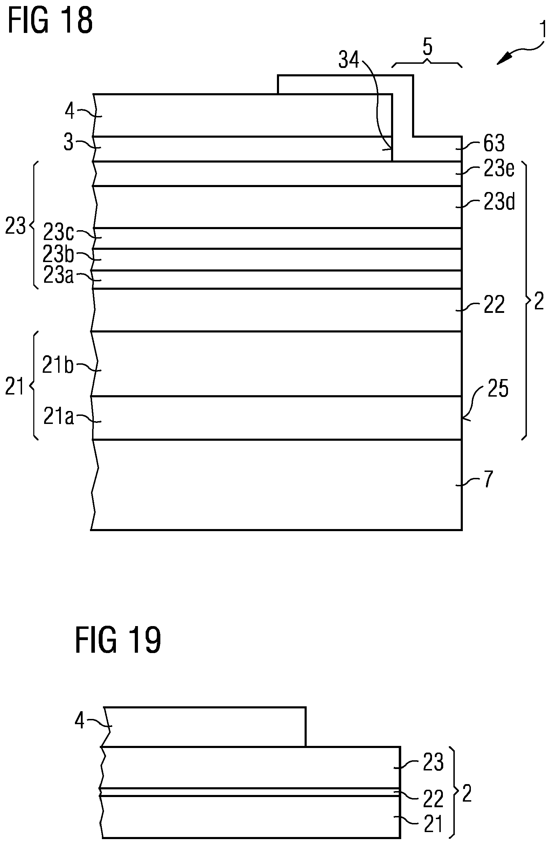

In der Abwandlung der Figur 18 ist ein Aufbau der Halbleiterschichtenfolge 2 detaillierter gezeigt. Ein solcher Aufbau liegt bevorzugt auch in allen anderen Abwandlungen und Ausführungsbeispielen vor. Der n-Bereich 21 ist, in Richtung weg vom Substrat 7, zusammengesetzt aus einer n-Mantelschicht 21a und einem n-Wellenleiter 21b. Im p-Bereich 23 liegen, in Richtung weg von der aktiven Zone 22, ein p-Wellenleiter 23a, 23c, eine p-Mantelschicht 23d sowie eine p-Halbleiterkontaktschicht 23e vor. Der gesamte p-Bereich basiert bevorzugt auf demselben Materialsystem. Optional ist der p-Wellenleiter in die zwei Teilschichten 23a, 23c aufgeteilt, zwischen denen sich eine Elektronenbarriereschicht 23b befinden kann.

Die elektrisch isolierende oder elektrisch schlecht leitende Zusatzschicht 63 bedeckt gemäß Figur 18 die metallische p-Kontaktstruktur 4 zum Teil.

In allen Abwandlungen und Ausführungsbeispielen ist es möglich, dass die Isolatorschicht 6, die Zusatzschicht 63 und/oder das Schutzmaterial 64 aus mehreren Teilschichten zusammengesetzt sind, wobei diese Teilschichten bevorzugt jeweils unmittelbar aufeinander folgen. Weiterhin können die Abwandlungen und Ausführungsbeispiele untereinander kombiniert werden, beispielsweise können im Zusammenhang mit Figur 7 jeweils Zusatzschichten 63 vorhanden sein, wie etwa in den Figuren 10 bis 17 gezeigt. Auch ist es in allen Abwandlungen und Ausführungsbeispielen möglich, dass die Facette 25 teilweise oder vollständig von der Zusatzschicht 63 oder auch von einem Schutzmaterial 64 und/oder der Isolatorschicht 6 bedeckt ist.

Die Halbleiterlaser 1 weisen insbesondere je zwei einander gegenüberliegende und parallel zueinander orientierte Facetten 25 auf. Die Facetten 25 sind besonders bevorzugt jeweils mit einem Stromschutzbereich 5 versehen, wobei beide Facetten durch einen gleichartigen Stromschutzbereich 5 gebildet sein können oder wobei auch unterschiedliche Stromschutzbereiche 5, wie in Verbindung mit den Figuren 1 bis 18 dargestellt, in einen einzigen Halbleiterlaser 1 miteinander kombiniert sein können.

In Figur 19 ist eine Abwandlung eines Halbleiterlasers gezeigt. Hierbei ist keine transparente p-Kontaktschicht vorhanden, so dass der p-Bereich 23 vergleichsweise dick ist, was zu einer Erhöhung eines Serienwiderstandes und/oder einer Vorwärtsspannung und damit zu einer limitierenden Effizienz führen kann. Demgegenüber weisen die Halbleiterlaser 1 der Figuren 1 bis 18 einen verbesserten Serienwiderstand aufgrund des Ersetzens der Mantelschicht durch die p-Kontaktschicht 3 auf. Ebenso ist eine Stabilität der Facette 25 erhöht, da keine Ladungsträgerrekombination direkt an der Facette 25 erfolgt. Durch die Zurückziehung einer Bestromung von der Facette 25 ist auch die Entstehung von Leckströmen über die Facette 25 hinweg vermieden. Weiterhin ist eine Kontamination der Facette 25 durch Metalle verhindert, da aus dem Facettenbereich alle Metallen eliminiert sein können. Außerdem erfolgt eine verbesserte Wärmeabfuhr durch hoch wärmeleitende Materialien aus dem Bereich der Facette 25 heraus, etwa durch die bündig mit der Facette 25 abschließende p-Kontaktstruktur 4.

Die hier beschriebene Erfindung ist nicht durch die Beschreibung anhand der Ausführungsbeispiele beschränkt, sondern lediglich durch den von den Ansprüchen definierten Schutzumfang.

### Bezugszeichenliste

- 1: Halbleiterlaser
- 2: Halbleiterschichtenfolge
- 21: n-Bereich
- 22: aktive Zone
- 23: p-Bereich
- 25: Facette
- 3: transparente p-Kontaktschicht
- 34: Seitenfläche der p-Kontaktschicht
- 4: metallische p-Kontaktstruktur
- 5: Stromschutzbereich
- 6: Isolatorschicht
- 61: Modifizierung des p-Bereichs
- 62: Modifizierung der p-Kontaktschicht
- 63: Zusatzschicht
- 64: Schutzmaterial
- 65: Mischmaterial
- 7: Substrat für die Halbleiterschichtenfolge
- I: Intensität der Laserstrahlung

## Patentansprüche

1. Halbleiterlaser (1) mit
- einer Halbleiterschichtenfolge (2), die einen n-leitenden n-Bereich (21), einen p-leitenden p-Bereich (23) und eine dazwischen liegende aktive Zone (22) zur Erzeugung von Laserstrahlung umfasst,
- einer für die Laserstrahlung durchlässigen p-Kontaktschicht (3) aus einem transparenten leitfähigen Oxid zur Stromeinprägung direkt in den p-Bereich (23), und
- einer elektrisch leitenden und metallischen p-Kontaktstruktur (4), die sich direkt an der p-Kontaktschicht (3) befindet,
wobei
- die p-Kontaktschicht (3) ein Teil einer Mantelschicht zur Führung der Laserstrahlung ist, sodass die Laserstrahlung im Betrieb des Halbleiterlasers (1) bestimmungsgemäß in die p-Kontaktschicht (3) eindringt,
- die Halbleiterschichtenfolge (2) zwei Facetten (25) aufweist, die Resonatorendflächen für die Laserstrahlung bilden,
- in wenigstens einem Stromschutzbereich (5) direkt an zumindest einer der Facetten (25) eine Stromeinprägung in den p-Bereich (23) unterdrückt ist,
- der Stromschutzbereich (5) in Richtung senkrecht zur zugehörigen Facette (25) eine Ausdehnung von mindestens 0,5 µm und von höchstens 100 µm und zusätzlich von höchstens 20 % einer Resonatorlänge für die Laserstrahlung aufweist, **dadurch gekennzeichnet, dass**
- in dem Stromschutzbereich (5) die p-Kontaktschicht (3) nur teilweise entfernt ist, sodass in dem Stromschutzbereich (5) ein effektiver Brechungsindex für die Laserstrahlung in Richtung hin zur zugehörigen Facette (25) abnimmt.

2. Halbleiterlaser (1) nach dem vorhergehenden Anspruch,
bei dem die p-Kontaktschicht (3) und die p-Kontaktstruktur (4) in Richtung parallel zur aktiven Zone (22) bündig mit mindestens einer der Facetten (25) abschließen.

3. Halbleiterlaser (1) nach einem der vorhergehenden Ansprüche,
bei dem sich in zumindest einem Stromschutzbereich (5) zwischen der p-Kontaktschicht (3) und dem p-Bereich (23) eine elektrisch Isolatorschicht (6) befindet, wobei die Isolatorschicht (6) eine konstante Dicke aufweist, die höchstens 1 µm beträgt.

4. Halbleiterlaser (1) nach einem der vorhergehenden Ansprüche,
bei dem in zumindest einem Stromschutzbereich (5) der p-Bereich (23) direkt an der p-Kontaktschicht (3) modifiziert ist, sodass in diesem Stromschutzbereich (5) eine Stromeinprägung in den p-Bereich (23) verhindert oder um mindestens einen Faktor 10 reduziert ist.

5. Halbleiterlaser (1) nach einem der vorhergehenden Ansprüche,
bei dem in zumindest einem Stromschutzbereich (5) die p-Kontaktschicht (3) direkt an dem p-Bereich (23) modifiziert ist, sodass in diesem Stromschutzbereich (5) eine Stromeinprägung in den p-Bereich (23) verhindert oder um mindestens einen Faktor 10 reduziert ist.

6. Halbleiterlaser (1) nach einem der vorhergehenden Ansprüche,
bei dem in zumindest einem Stromschutzbereich (5) die p-Kontaktschicht (3) und/oder die p-Kontaktstruktur (4) entfernt sind.

7. Halbleiterlaser (1) nach einem der vorhergehenden Ansprüche,
bei dem in zumindest einem Stromschutzbereich (5) die p-Kontaktschicht (3) entfernt ist und in dem Stromschutzbereich (5) zumindest eine Zusatzschicht (63) direkt an dem p-Bereich (23) aufgebracht ist, wobei die Zusatzschicht (63) elektrisch isolierend ist.

8. Halbleiterlaser (1) nach dem vorhergehenden Anspruch, bei dem die Zusatzschicht (63) eine höhere spezifische thermische Leitfähigkeit aufweist als der p-Bereich (23) .

9. Halbleiterlaser (1) nach einem der vorhergehenden Ansprüche,
bei dem in zumindest einem Stromschutzbereich (5) die p-Kontaktschicht (3) teilweise entfernt ist und Gebiete, aus denen die p-Kontaktschicht (3) entfernt ist, mit einem für die Laserstrahlung transparenten und elektrisch isolierenden Schutzmaterial (64) aufgefüllt sind.

10. Halbleiterlaser (1) nach einem der vorhergehenden Ansprüche,
bei dem in zumindest einem Stromschutzbereich (5) ein Material der p-Kontaktschicht (3) mit einem transparenten und elektrisch isolierenden Mischmaterial (65) durchmischt ist,
wobei ein Anteil des Mischmaterials (65) in Richtung hin zur betreffenden Facette (25) und/oder in Richtung weg von der aktiven Zone (22) graduell oder stufenförmig zunimmt.

11. Halbleiterlaser (1) nach zumindest Anspruch 7,
bei dem in zumindest einem Stromschutzbereich (5) die p-Kontaktschicht (3) vollständig entfernt ist, wobei die p-Kontaktstruktur (4) eine Seitenfläche (34) der p-Kontaktschicht (3) vollständig bedeckt,
wobei in dem Stromschutzbereich (5) zusätzlich die Zusatzschicht (63) aufgebracht ist, sodass in Richtung parallel zur aktiven Zone (22) die p-Kontaktschicht (3), die p-Kontaktstruktur (4) und die Zusatzschicht (63) aufeinander folgen.

12. Halbleiterlaser (1) nach zumindest Anspruch 7,
bei dem in zumindest einem Stromschutzbereich (5) die Zusatzschicht (63) sowohl in dem Stromschutzbereich (5) als auch auf der zugehörigen Facette (25) aufgebracht ist.

13. Halbleiterlaser (1) nach zumindest Anspruch 7,
bei dem nahe zumindest eines Stromschutzbereichs (5) die Zusatzschicht (63) auf die p-Kontaktschicht (3) aufgebracht ist und in direktem Kontakt mit der p-Kontaktstruktur (4) steht.

14. Halbleiterlaser (1) nach zumindest Anspruch 7,
bei dem in zumindest einem Stromschutzbereich (5) die Zusatzschicht (63) teilweise oder vollständig von der p-Kontaktstruktur (4) bedeckt ist,
wobei eine Dicke der Zusatzschicht (63) gleich einer Dicke der p-Kontaktschicht (3) ist.

15. Halbleiterlaser (1) nach zumindest Anspruch 7,
bei dem in zumindest einem Stromschutzbereich (5) die Zusatzschicht (63) von der p-Kontaktschicht (3) beabstandet ist, in Richtung parallel zur aktiven Zone (22) .

## Claims

1. A semiconductor laser (1) comprising
- a semiconductor layer sequence (2) which comprises an n-conducting n-region (21), a p-conducting p-region (23) and an active zone (22) lying therebetween for generating laser radiation,
- a p-contact layer (3) which is permeable to the laser radiation and is of a transparent conductive oxide for impressing current directly into the p-region (23), and
- an electrically conductive and metallic p-contact structure (4) which is located directly on the p-contact layer (3),
wherein
- the p-contact layer (3) is a part of a cladding layer for guiding the laser radiation, such that the laser radiation penetrates intentionally into the p-contact layer (3) during operation of the semiconductor laser (1),
- the semiconductor layer sequence (2) has two facets (25) which form resonator end faces for the laser radiation,
- a current impression in the p-region (23) is suppressed directly on at least one of the facets (25) in at least one current protection region (5),
- the current protection region (5) has, in a direction perpendicular to the associated facet (25), an extent of at least 0.5 um and of at most 100 um and additionally of at most 20% of a resonator length for the laser radiation, **characterized in that**
- the p-contact layer (3) is only partially removed in the current protection region (5), so that an effective refractive index for the laser radiation decreases in the direction of the associated facet (25) in the current protection region (5).

2. The semiconductor laser (1) according to the preceding claim,
wherein the p-contact layer (3) and the p-contact structure (4) terminate flush with at least one of the facets (25) in the direction parallel to the active zone (22).

3. The semiconductor laser (1) according to one of the preceding claims,
wherein an electrically insulating layer (6) is located in at least one current protection region (5) between the p-contact layer (3) and the p-region (23),
wherein the insulating layer (6) has a constant thickness which is at most 1 um.

4. The semiconductor laser (1) according to one of the preceding claims,
wherein the p-region (23) is modified directly on the p-contact layer (3) in at least one current-protection region (5), so that a current impression in the p-region (23) is prevented or is reduced by at least a factor of 10 in this current-protection region (5).

5. The semiconductor laser (1) according to one of the preceding claims,
wherein the p-contact layer (3) is modified directly at the p-region (23) in at least one current protection region (5), so that in this current protection region (5) a current impression into the p-region (23) is prevented or is reduced by at least a factor of 10.

6. The semiconductor laser (1) according to one of the preceding claims,
wherein the p-contact layer (3) and/or the p-contact structure (4) are removed in at least one current protection region (5).

7. The semiconductor laser (1) according to one of the preceding claims,
wherein the p-contact layer (3) is removed in at least one current protection region (5) and at least one additional layer (63) is applied directly to the p-region (23) in said current protection region (5),
wherein the additional layer (63) is electrically insulating.

8. The semiconductor laser (1) according to the preceding claim,
wherein the additional layer (63) has a higher specific thermal conductivity than the p-region (23).

9. The semiconductor laser (1) according to one of the preceding claims,
wherein the p-contact layer (3) is partially removed in at least one current protection region (5) and regions from which the p-contact layer (3) is removed are filled with a protective material (64) which is transparent to the laser radiation and which is electrically insulating.

10. The semiconductor laser (1) according to one of the preceding claims,
wherein a material of the p-contact layer (3) is mixed with a transparent and electrically insulating mixing material (65) in at least one current protection region (5),
wherein a proportion of the mixing material (65) increases gradually or stepwise towards the respective facet (25) and/or in a direction away from the active zone (22).

11. The semiconductor laser (1) according to at least claim 7,
wherein the p-contact layer (3) is completely removed in at least one current protection region (5), wherein the p-contact structure (4) completely covers a side surface (34) of the p-contact layer (3),
wherein the additional layer (63) is additionally applied in the current protection region (5) such that the p-contact layer (3), the p-contact structure (4) and the additional layer (63) follow one another in the direction parallel to the active zone (22).

12. The semiconductor laser (1) according to at least claim 7,
wherein the additional layer (63) is applied in at least one current protection region (5) both in the current protection region (5) and on the associated facet (25).

13. The semiconductor laser (1) according to at least claim 7,
wherein the additional layer (63) is applied to the p-contact layer (3) close to at least one current protection region (5) and is in direct contact with the p-contact structure (4).

14. The semiconductor laser (1) according to at least claim 7,
wherein the additional layer (63) is partially or completely covered by the p-contact structure (4) in at least one current protection region (5),
wherein a thickness of the additional layer (63) is equal to a thickness of the p-contact layer (3).

15. The semiconductor laser (1) according to at least claim 7,
wherein the additional layer (63) is spaced apart from the p-contact layer (3) in at least one current protection region (5), in a direction parallel to the active zone (22).

## Revendications

1. Un laser à semi-conducteur (1) comprenant
- une succession de couches semi-conductrices (2) qui comprend une zone n conductrice n (21), une zone p conductrice p (23) et une zone active (22) disposée entre elles pour générer un rayonnement laser,
- une couche de contact p (3) qui est perméable au rayonnement laser et qui est constituée d'un oxyde conducteur transparent pour imprimer un courant directement dans la région p (23), et
- une structure de contact p (4) électriquement conductrice et métallique qui est située directement sur la couche de contact p (3),
dans lequelle
- la couche de contact p (3) fait partie d'une couche de gainage pour guider le rayonnement laser, de telle sorte que le rayonnement laser pénètre intentionnellement dans la couche de contact p (3) pendant le fonctionnement du laser à semi-conducteur (1),
- la succession de couches semi-conductrices (2) présente deux facettes (25) qui forment des faces d'extrémité de résonateur pour le rayonnement laser,
- une impression actuelle dans la région p (23) est supprimée directement sur au moins l'une des facettes (25) dans au moins une région de protection actuelle (5),
- la zone de protection de courant (5) présente, dans une direction perpendiculaire à la facette associée (25), une étendue d'au moins 0,5 µm et d'au plus 100 µm et en outre d'au plus 20 % d'une longueur de résonateur pour le rayonnement laser,
**caractérisé en ce que**
- la couche de contact p (3) est retirée seulement partiellement dans la région de protection de courant (5), de telle sorte qu'un indice de réfraction efficace pour le rayonnement laser diminue dans la direction de la facette associée (25) dans la région de protection actuelle (5).

2. Le laser à semi-conducteur (1) selon la revendication précédente,
dans lequelle la couche de contact p (3) et la structure de contact p (4) se terminant en affleurement avec au moins l'une des facettes (25) dans la direction parallèle à la zone active (22).

3. Le laser à semi-conducteur (1) selon l'une des revendications précédentes,
dans lequelle une couche électriquement isolante (6) étant située dans au moins une zone de protection contre le courant (5) entre la couche de contact p (3) et la zone p (23),
dans lequelle la couche isolante (6) ayant une épaisseur constante qui est d'au plus 1 µm.

4. Le laser à semi-conducteur (1) selon l'une des revendications précédentes,
dans lequelle la zone p (23) étant modifiée directement sur la couche de contact p (3) dans au moins une zone de protection contre le courant (5), de sorte qu'une impression de courant dans la zone p (23) est empêchée ou réduite d'au moins un facteur 10 dans cette zone de protection contre le courant (5).

5. Le laser à semi-conducteur (1) selon l'une des revendications précédentes,
dans lequelle la couche de contact p (3) étant modifiée directement au niveau de la région p (23) dans au moins une région de protection actuelle (5), de telle sorte que, dans cette région de protection actuelle (5), une impression actuelle dans la région p (23) est empêchée ou est réduite d'au moins un facteur de 10.

6. Le laser à semi-conducteur (1) selon l'une des revendications précédentes,
dans lequelle la couche de contact p (3) et/ou la structure de contact p (4) étant retirées dans au moins une zone de protection de courant (5).

7. Le laser à semi-conducteur (1) selon l'une des revendications précédentes,
dans lequelle la couche de contact p (3) étant retirée dans au moins une zone de protection de courant (5) et au moins une couche supplémentaire (63) étant appliquée directement sur la zone p (23) dans ladite zone de protection de courant (5),
dans lequelle la couche supplémentaire (63) étant électriquement isolante.

8. Le laser à semi-conducteur (1) selon la revendication précédente,
dans lequelle la couche supplémentaire (63) ayant une conductivité thermique spécifique supérieure à celle de la région p (23).

9. Le laser à semi-conducteur (1) selon l'une des revendications précédentes,
dans lequelle la couche de contact p (3) étant partiellement retirée dans au moins une zone de protection de courant (5) et des zones à partir desquelles la couche de contact p (3) est retirée étant remplies d'un matériau de protection (64) qui est transparent au rayonnement laser et qui est électriquement isolant.

10. Le laser à semi-conducteur (1) selon l'une des revendications précédentes,
dans lequelle un matériau de la couche de contact p (3) est mélangé à un matériau de mélange (65) transparent et électriquement isolant dans au moins une zone de protection (5),
dans lequelle une proportion du matériau de mélange (65) augmentant progressivement ou progressivement vers la facette respective (25) et/ou dans une direction s'éloignant de la zone active (22).

11. Le laser à semi-conducteur (1) selon au moins la revendication 7,
dans lequelle la couche de contact p (3) étant complètement retirée dans au moins une région de protection de courant (5), la structure de contact p (4) recouvrant complètement une surface latérale (34) de la couche de contact p (3),
dans lequelle la couche supplémentaire (63) étant en outre appliquée dans la zone de protection de courant (5) de telle sorte que la couche de contact p (3), la structure de contact p (4) et la couche supplémentaire (63) se suivent dans la direction parallèle à la zone active (22).

12. Le laser à semi-conducteur (1) selon au moins la revendication 7,
dans lequelle la couche supplémentaire (63) étant appliquée dans au moins une zone de protection de courant (5) à la fois dans la zone de protection de courant (5) et sur la facette associée (25).

13. Le laser à semi-conducteur (1) selon au moins la revendication 7,
dans lequelle la couche supplémentaire (63) étant appliquée sur la couche de contact p (3) à proximité d'au moins une zone de protection de courant (5) et étant en contact direct avec la structure de contact p (4).

14. Le laser à semi-conducteur (1) selon au moins la revendication 7,
dans lequelle la couche supplémentaire (63) étant recouverte partiellement ou complètement par la structure de contact p (4) dans au moins une région de protection actuelle (5), dans lequelle une épaisseur de la couche supplémentaire (63) étant égale à une épaisseur de la couche de contact p (3).

15. Le laser à semi-conducteur (1) selon au moins la revendication 7,
dans lequelle la couche supplémentaire (63) étant espacée de la couche de contact p (3) dans au moins une zone de protection de courant (5), dans une direction parallèle à la zone active (22).
